# EUROPEAN PATENT APPLICATION

(11) **EP 4 439 980 A1**
(43) Date of publication of application: **02.10.2024**
(21) Application number: 21969793.5
(22) Date of filing: 31.12.2021
(51) Int. Cl.: H03F 3/189, H04W 52/52

(54) **POWER-AMPLIFIER POWER SUPPLY CIRCUIT AND COMMUNICATION DEVICE**

(71) Applicant: Huawei Technologies Co., Ltd., Shenzhen, Guangdong 518129 (CN)
(72) Inventor: ZHOU, Wei, Shenzhen, Guangdong 518129 (CN); QIAN, Yao, Shenzhen, Guangdong 518129 (CN); PAN, Xiaojun, Shenzhen, Guangdong 518129 (CN); LI, Weinan, Shenzhen, Guangdong 518129 (CN)
(74) Representative: Goddar, Heinz J.
(86) International application number: PCT/CN2021/143912
(87) International publication number: WO 2023/123448

(57) **Abstract**

This application discloses a power amplifier power supply circuit and a communication apparatus, and relates to the communication field, to improve work efficiency of a power component. The power amplifier power supply circuit includes a first power supply circuit and a second power supply circuit that are connected in parallel, where the first power supply circuit and the second power supply circuit jointly supply power to a power amplifier by using a power supply end of the power amplifier. The second power supply circuit is configured to adjust a power supply voltage of the power amplifier at a symbol level. Power supply voltages output by the second power supply circuit and the first power supply circuit change based on a change of an envelope signal output by the power amplifier.

## Description

### TECHNICAL FIELD

This application relates to the communication field, and in particular, to a power amplifier power supply circuit and a communication apparatus.

### BACKGROUND

In a radio frequency communication system, an output end of a radio frequency transmitter is coupled to an input end of a power amplifier (power amplifier, PA). The PA is configured to perform power amplification on a radio frequency signal output by the radio frequency transmitter.

How to improve work efficiency of the PA or another similar power component by improving a power supply circuit is one of current challenges.

### SUMMARY

Embodiments of this application provide a power amplifier power supply circuit and a communication apparatus, to improve work efficiency of a power component.

To achieve the foregoing objective, the following technical solutions are used in embodiments of this application.

According to a first aspect, a power amplifier power supply circuit is provided, and includes a first power supply circuit and a second power supply circuit that are connected in parallel, where the first power supply circuit and the second power supply circuit jointly supply power to a power amplifier by using a power supply end of the power amplifier. The second power supply circuit is configured to adjust a power supply voltage of the power amplifier at a symbol level. Power supply voltages output by the second power supply circuit and the first power supply circuit change based on a change of an envelope signal output by the power amplifier.

In the power amplifier power supply circuit provided in this embodiment of this application, the first power supply circuit supplies power to the power amplifier, and the second power supply circuit adjusts the power supply voltage of the power amplifier at the symbol level. Because the envelope signal that determines transmit power of the power amplifier or another similar power device changes more rapidly with further evolution of a protocol, it is introduced to adjust the power supply voltage at the symbol level. A power supply voltage required by the power amplifier or the another similar power device at a moment varies with instantaneous transmit power. Therefore, dynamically adjusting the power supply voltage of the power amplifier or the another similar power device can improve work efficiency of the power amplifier or the another similar power device.

In a possible implementation, the second power supply circuit is configured to: output a first power supply voltage at a first symbol, and output a second power supply voltage at a second symbol. The first symbol and the second symbol are set to be adjacent. A first symbol interval is set between the first symbol and the second symbol. The first power supply voltage is different from the second power supply voltage. The second power supply circuit is configured to implement conversion from the first power supply voltage to the second power supply voltage at the first symbol interval, to adjust the power supply voltage of the power amplifier at the symbol level. That is, a power supply voltage of the PA at each symbol can be adjusted.

In a possible implementation, the first power supply circuit is a direct current-direct current converter circuit, and the second power supply circuit is a fast current charger circuit. The direct current-direct current converter circuit may use a boost (Boost) circuit, a buck (Buck) voltage, a buck-boost (Buck-Boost) circuit, or the like.

In a possible implementation, the second power supply circuit includes a main power supply branch. The main power supply branch includes a main charging transistor and a main discharging transistor that are coupled in series. A connection point between the main charging transistor and the main discharging transistor is configured to be coupled to the power supply end of the power amplifier. The main power supply branch further includes a first gate driving circuit. The first gate driving circuit is configured to: input a sampling voltage corresponding to the power supply voltage and a reference signal corresponding to the sampling voltage, and output a gate driving signal to the main charging transistor and the main discharging transistor. The main power supply branch is configured to: accelerate a jump of the power supply voltage that tracks a reference signal of the power amplifier, and shorten jump time.

In a possible implementation, the first gate driving circuit includes a first comparator and a second comparator. The first comparator is configured to: compare the input sampling voltage with an input first reference voltage, and output a comparison result to the main charging transistor. The second comparator is configured to: compare the input sampling voltage with an input second reference voltage, and output a comparison result to the main discharging transistor. When the reference signal has a rise jump, the first comparator drives the main charging transistor to be turned on, so that the first power supply circuit is connected to a power supply voltage through the main charging transistor; and the second comparator drives the main discharging transistor to be turned off. The main power supply branch outputs a first charge current to an output end of the first power supply circuit through the main charging transistor, so that a power supply voltage output by an output end of the power amplifier power supply circuit increases more rapidly. When the reference signal has a falling jump, the second comparator drives the main discharging transistor to be turned on, so that the first power supply circuit is grounded through the main discharging transistor; and the first comparator drives the main charging transistor to be turned off. The main power supply branch outputs the first discharge current to the output end of the first power supply circuit through the main discharging transistor, so that the power supply voltage output by the output end of the power amplifier power supply circuit decreases more rapidly until the sampling voltage is less than the second reference voltage.

In a possible implementation, a non-inverting input end of the first comparator is configured to input the sampling voltage, an inverting input end of the first comparator is configured to input the first reference voltage, and an output end of the first comparator is coupled to a gate of the main charging transistor. A non-inverting input end of the second comparator is configured to input the sampling voltage, an inverting input end of the second comparator is configured to input the second reference voltage, and an output end of the second comparator is coupled to a gate of the main discharging transistor. The first reference voltage and the second reference voltage are obtained based on the reference signal, and the first reference voltage is less than the second reference voltage. When the reference signal has a rise jump, the first comparator outputs a low electrical level, and the main charging transistor is turned on, so that the first power supply circuit is connected to the power supply voltage through the main charging transistor; and the second comparator outputs a low electrical level, so that the main discharging transistor is turned off. The main power supply branch outputs a first charge current to the output end of the first power supply circuit through the main charging transistor, so that the power supply voltage output by the output end of the power amplifier power supply circuit increases more rapidly until the sampling voltage is greater than the first reference voltage. When the reference signal has a falling jump, the second comparator outputs a high electrical level, and the main discharging transistor is turned on, so that the first power supply circuit is grounded through the main discharging transistor; and the first comparator outputs a high electrical level, so that the main charging transistor is turned off. The main power supply branch outputs the first discharge current to the output end of the first power supply circuit through the main discharging transistor, so that the power supply voltage output by the output end of the power amplifier power supply circuit decreases more rapidly until the sampling voltage is less than the second reference voltage.

In a possible implementation, the first reference voltage and the second reference voltage are obtained based on the reference signal, and the first reference voltage is less than the second reference voltage. For a specific technical effect, refer to the technical effect of the previous implementation.

In a possible implementation, the first gate driving circuit includes an error amplifier, a first comparator, and a second comparator. The error amplifier is configured to: compare the input sampling voltage with the input reference signal, and output a first comparison result to the first comparator and the second comparator. The first comparator is configured to: compare the input first comparison result with a fifth reference voltage, and output a comparison result to the main charging transistor. The second comparator is configured to: compare the input first comparison result with a sixth reference voltage, and output a comparison result to the main discharging transistor. When the reference signal has a rise jump, a difference between the reference signal and the sampling voltage instantaneously becomes larger, and an error signal output by the error amplifier is also large. The first comparator drives the main charging transistor to be turned on, so that the first power supply circuit is connected to a power supply voltage through the main charging transistor. The second comparator drives the main discharging transistor to be turned off. The main power supply branch outputs a first charge current to an output end of the first power supply circuit through the main charging transistor, so that a power supply voltage output by an output end of the power amplifier power supply circuit increases more rapidly. As the power supply voltage and the sampling voltage gradually increase, the error signal gradually decreases. The main power supply branch stops outputting the first charge current to the output end of the first power supply circuit. When the reference signal has a falling jump, the difference between the reference signal and the sampling voltage instantaneously becomes smaller, and the error signal output by the error amplifier is also small. The second comparator drives the main discharging transistor to be turned on, so that the first power supply circuit is grounded through the main discharging transistor. The first comparator drives the main charging transistor to be turned off. The main power supply branch outputs a first discharge current to the output end of the first power supply circuit through the main discharging transistor, so that the power supply voltage output by the output end of the power amplifier power supply circuit decreases more rapidly. As the power supply voltage and the sampling voltage gradually decrease, the error signal gradually increases. The main power supply branch stops outputting the first discharge current to the output end of the first power supply circuit.

In a possible implementation, an inverting input end of the error amplifier is configured to input the sampling voltage, a non-inverting input end of the error amplifier is configured to input the reference signal, and an output end of the error amplifier is coupled to an inverting input end of the first comparator and an inverting input end of the second comparator. A non-inverting input end of the first comparator is configured to input the fifth reference voltage, and an output end of the first comparator is coupled to a gate of the main charging transistor. A non-inverting input end of the second comparator is configured to input the sixth reference voltage, and an output end of the second comparator is coupled to a gate of the main discharging transistor. When the reference signal has a rise jump, the difference between the reference signal and the sampling voltage instantaneously becomes larger, and the error signal is also large. When the error signal is greater than the fifth reference signal, the first comparator outputs a low electrical level, and the main charging transistor is turned on, so that the first power supply circuit is connected to the power supply voltage through the main charging transistor. The second comparator outputs a low electrical level, so that the main discharging transistor is turned off. The main power supply branch outputs the first charge current to the output end of the first power supply circuit through the main charging transistor, so that the power supply voltage output by the output end of the power amplifier power supply circuit increases more rapidly. As the power supply voltage and the sampling voltage gradually increase, the error signal gradually decreases. Until the error signal is less than the fifth reference voltage, the main power supply branch stops outputting the first charge current to the output end of the first power supply circuit. When the reference signal has a falling jump, the difference between the reference signal and the sampling voltage instantaneously becomes smaller, and the error signal is also small. When the error signal is less than the sixth reference signal, the second comparator outputs a high electrical level, and the main discharging transistor is turned on, so that the first power supply circuit is grounded through the main discharging transistor. The first comparator outputs a high electrical level, so that the main charging transistor is turned off. The main power supply branch outputs the first discharge current to the output end of the first power supply circuit through the main discharging transistor, so that the power supply voltage output by the output end of the power amplifier power supply circuit decreases more rapidly. As the power supply voltage and the sampling voltage gradually decrease, the error signal gradually increases. Until the error signal is greater than the sixth reference voltage, the main power supply branch stops outputting the first discharge current to the output end of the first power supply circuit.

In a possible implementation, the power amplifier power supply circuit includes a fifth comparator. The fifth comparator is configured to: compare the input first comparison result with a triangular wave signal, and output a comparison result to the first power supply circuit, to adjust power supply of the first power supply circuit. When the reference signal has a rise jump, the difference between the reference signal and the sampling voltage instantaneously becomes larger, the error signal is also large, and a duty of a modulation signal output by the fifth comparator increases. Therefore, a power supply voltage output by the first power supply circuit is increased, so that the power supply voltage output by the first power supply circuit fast follows the rise jump of the reference signal. When the reference signal has a falling jump, the reference signal is instantaneously less than the sampling voltage, the error signal output by the error amplifier is small, and the duty of the modulation signal output by the fifth comparator decreases. Therefore, the power supply voltage output by the first power supply circuit is decreased, so that the power supply voltage output by the first power supply circuit fast follows the falling jump of the reference signal.

In a possible implementation, a non-inverting input end of the fifth comparator is coupled to the output end of the error amplifier, an inverting input end of the fifth comparator is configured to input the triangular wave signal, and an output end of the fifth comparator is coupled to a control end of the first power supply circuit, to adjust the power supply of the first power supply circuit. When the reference signal has a rise jump, the difference between the reference signal and the sampling voltage instantaneously becomes larger, the error signal is also large, and the duty of the modulation signal output by the fifth comparator increases. Therefore, the power supply voltage output by the first power supply circuit is increased, so that the power supply voltage output by the first power supply circuit fast follows the rise jump of the reference signal. When the reference signal has a falling jump, the reference signal is instantaneously less than the sampling voltage, the error signal output by the error amplifier is small, and the duty of the modulation signal output by the fifth comparator decreases. Therefore, the power supply voltage output by the first power supply circuit is decreased, so that the power supply voltage output by the first power supply circuit fast follows the falling jump of the reference signal.

In a possible implementation, the first gate driving circuit further includes a first driving circuit and a second driving circuit. The comparison result output by the first comparator is output to the main charging transistor through the first driving circuit. The comparison result output by the second comparator is output to the main discharging transistor through the second driving circuit. The driving circuit is configured to supply a driving current to a power supply transistor.

In a possible implementation, the output end of the first comparator is coupled to the gate of the main charging transistor through the first driving circuit, and the output end of the second comparator is coupled to the gate of the main discharging transistor through the second driving circuit. The driving circuit is configured to supply a driving current to a power supply transistor.

In a possible implementation, the main charging transistor includes a plurality of first charging transistors connected in parallel, and the main discharging transistor includes a plurality of first discharging transistors connected in parallel. The power amplifier power supply circuit is configured to provide an enable signal, to control a quantity of opened or closed charging transistors in the plurality of first charging transistors and/or a quantity of opened or closed discharging transistors in the plurality of first discharging transistors. When the power supply voltage decreases, a current output by a single group of a first charging transistor and a first discharging transistor that are connected in series also decreases, and the enable signal selects more groups of first charging transistors and first discharging transistors that are connected in series to work. When the power supply voltage increases, a current output by a single group of a first charging transistor and a first discharging transistor that are connected in series also increases, and the enable signal selects fewer groups of first charging transistors and first discharging transistors that are connected in series to work. When a difference between a second target voltage and a first target voltage decreases, that is, an amplitude of the rise jump or the falling jump of the reference signal is small, a current required for the jump is also small, and the enable signal selects fewer groups of first charging transistors and first discharging transistors that are connected in series to work. When the difference between the second target voltage and the first target voltage increases, that is, the amplitude of the rise jump or the falling jump of the reference signal is large, the current required for the jump is also large, and the enable signal selects more groups of first charging transistors and first discharging transistors that are connected in series to work. A charge current or a discharge current supplied by a single group of a first charging transistor and a first discharging transistor that are connected in series is in direct proportional to a difference between a source gate voltage and a threshold voltage. When a threshold voltage of a power supply transistor in a plurality of groups of first charging transistors and first discharging transistors that are connected in series is smaller, the enable signal selects fewer groups of first charging transistors and first discharging transistors that are connected in series to work. When the threshold voltage of the power supply transistor in the plurality of groups of first charging transistors and first discharging transistors that are connected in series is larger, the enable signal selects more groups of first charging transistors and first discharging transistors that are connected in series to work.

In a possible implementation, the second power supply circuit further includes an auxiliary power supply branch, and a current supplied by the auxiliary power supply branch is less than a current supplied by the main power supply branch. The auxiliary power supply branch is configured to compensate for overvoltage or undervoltage when the power supply voltage jumps, to accelerate stability of the power supply voltage.

In a possible implementation, the auxiliary power supply branch includes an auxiliary charging transistor and an auxiliary discharging transistor that are coupled in series, and a connection point between the auxiliary charging transistor and the auxiliary discharging transistor is configured to be coupled to the power supply end of the power amplifier. The auxiliary power supply branch further includes a second gate driving circuit. The second gate driving circuit is configured to: input the sampling voltage corresponding to the power supply voltage and a target voltage corresponding to the power supply voltage, and output a gate driving signal to the auxiliary charging transistor and the auxiliary discharging transistor. That is, the sampling voltage and the reference signal determine power supply of the auxiliary charging transistor and the auxiliary discharging transistor to the power amplifier.

In a possible implementation, the second gate driving circuit includes a third comparator and a fourth comparator. The third comparator is configured to: compare the input sampling voltage with an input third reference voltage, and output a comparison result to the auxiliary charging transistor. The fourth comparator is configured to: compare the input sampling voltage with an input fourth reference voltage, and output a comparison result to the auxiliary discharging transistor. When the third comparator drives the auxiliary charging transistor to be turned on so that the first power supply circuit is connected to the power supply voltage through the auxiliary charging transistor, and the fourth comparator drives the auxiliary discharging transistor to be turned off, the auxiliary power supply branch outputs a second charge current to the output end of the first power supply circuit through the auxiliary charging transistor, to alleviate undervoltage of the power supply voltage and accelerate stability of the power supply voltage. When the fourth comparator drives the auxiliary discharging transistor to be turned on so that the first power supply circuit is grounded through the auxiliary discharging transistor, and the third comparator drives the auxiliary charging transistor to be turned off, the auxiliary power supply branch outputs a second discharge current to the output end of the first power supply circuit through the auxiliary discharging transistor, to alleviate overvoltage of the power supply voltage and accelerate stability of the power supply voltage.

In a possible implementation, a non-inverting input end of the third comparator is configured to input the sampling voltage, an inverting input end of the third comparator is configured to input the third reference voltage, and an output end of the third comparator is coupled to a gate of the auxiliary charging transistor. A non-inverting input end of the fourth comparator is configured to input the sampling voltage, an inverting input end of the fourth comparator is configured to input the fourth reference voltage, and an output end of the fourth comparator is coupled to a gate of the auxiliary discharging transistor. If the sampling voltage is less than the third reference voltage (that is, the power supply voltage is undervoltaged), the third comparator outputs a low electrical level, and the auxiliary charging transistor is turned on, so that the first power supply circuit is connected to the power supply voltage through the auxiliary charging transistor; and the fourth comparator outputs a low electrical level, so that the auxiliary discharging transistor is turned off. The auxiliary power supply branch outputs the second charge current to the output end of the first power supply circuit through the auxiliary charging transistor, to alleviate undervoltage of the power supply voltage and accelerate stability of the power supply voltage. If the sampling voltage is greater than the fourth reference voltage (that is, the power supply voltage is overvoltaged), the fourth comparator outputs a high electrical level, and the auxiliary discharging transistor is turned on, so that the first power supply circuit is grounded through the auxiliary discharging transistor; and the third comparator outputs a high electrical level, so that the auxiliary charging transistor is turned off. The auxiliary power supply branch outputs the second discharge current to the output end of the first power supply circuit through the auxiliary discharging transistor, to alleviate overvoltage of the power supply voltage and accelerate stability of the power supply voltage.

In a possible implementation, the second gate driving circuit further includes a third driving circuit and a fourth driving circuit. The comparison result output by the third comparator is output to the auxiliary charging transistor through the third driving circuit. The comparison result output by the fourth comparator is output to the auxiliary discharging transistor through the fourth driving circuit. The driving circuit is configured to supply a driving current to a power supply transistor.

In a possible implementation, the output end of the third comparator is coupled to the gate of the auxiliary charging transistor through the third driving circuit. The output end of the fourth comparator is coupled to the gate of the auxiliary discharging transistor through the fourth driving circuit. The driving circuit is configured to supply a driving current to a power supply transistor.

In a possible implementation, the third reference voltage and the fourth reference voltage are obtained based on the reference signal, and the third reference voltage is less than the fourth reference voltage.

In a possible implementation, the first power supply circuit includes a load inductor, a load capacitor, and a direct current charging transistor and a direct current discharging transistor that are coupled in series. A third connection point between the direct current charging transistor and the direct current discharging transistor is grounded by using the load capacitor, and is further configured to be coupled to the power amplifier by using the load inductor. This implementation provides a specific circuit structure of a buck circuit.

In a possible implementation, a linear amplifier and a linear amplifier power supply circuit are further included. The linear amplifier power supply circuit is configured to supply power to the linear amplifier. The linear amplifier is configured to supply power to the power amplifier. A first power supply voltage output by the first power supply circuit and the second power supply circuit that are connected in parallel may be considered as a low-frequency direct-current component, and a second power supply voltage output by the linear amplifier may be considered as a high-frequency alternating-current component. The first power supply voltage and the second power supply voltage are superimposed and then output to the power amplifier by using the output end of the power amplifier power supply circuit, to improve work efficiency of the power amplifier as much as possible.

In a possible implementation, a capacitor and a switch are further included. An output end of the linear amplifier is coupled to the output end of the power amplifier power supply circuit by using the capacitor, and the output end of the linear amplifier is further grounded by using the switch. When the switch is turned on, the first power supply circuit and the second power supply circuit that are connected in parallel may output the first power supply voltage to the power amplifier based on the reference signal. When the switch is turned off, the first power supply circuit and the second power supply circuit that are connected in parallel may output the first power supply voltage to the power amplifier based on the reference signal, and the linear amplifier may output the second power supply voltage to the power amplifier.

According to a second aspect, a power amplifier power supply circuit is provided, and includes a direct current-direct current converter circuit and a fast current charger circuit that are connected in parallel. The direct current-direct current converter circuit and the fast current charger circuit jointly supply power to a power amplifier by using a power supply end of the power amplifier. The fast current charger circuit includes a main power supply branch and an auxiliary power supply branch, and a current supplied by the auxiliary power supply branch is less than a current supplied by the main power supply branch.

According to the power amplifier power supply circuit provided in this embodiment of this application, the main power supply branch is configured to: accelerate a jump of a power supply voltage tracking a reference signal of the power amplifier, and shorten jump time. The auxiliary power supply branch is configured to compensate for overvoltage or undervoltage when the power supply voltage jumps, to accelerate stability of the power supply voltage.

In a possible implementation, the fast current charger circuit includes the main power supply branch. The main power supply branch includes a main charging transistor and a main discharging transistor that are coupled in series. A connection point between the main charging transistor and the main discharging transistor is configured to be coupled to the power supply end of the power amplifier. The main power supply branch further includes a first gate driving circuit. The first gate driving circuit is configured to: input a sampling voltage corresponding to the power supply voltage and a reference signal corresponding to the sampling voltage, and output a gate driving signal to the main charging transistor and the main discharging transistor. The main power supply branch is configured to: accelerate the jump of the power supply voltage tracking the reference signal of the power amplifier, and shorten the jump time.

In a possible implementation, the first gate driving circuit includes a first comparator and a second comparator. The first comparator is configured to: compare the input sampling voltage with an input first reference voltage, and output a comparison result to the main charging transistor. The second comparator is configured to: compare the input sampling voltage with an input second reference voltage, and output a comparison result to the main discharging transistor. When the reference signal has a rise jump, the first comparator drives the main charging transistor to be turned on, so that the direct current-direct current converter circuit is connected to a power supply voltage through the main charging transistor; and the second comparator drives the main discharging transistor to be turned off. The main power supply branch outputs a first charge current to an output end of the direct current-direct current converter circuit through the main charging transistor, so that a power supply voltage output by an output end of the power amplifier power supply circuit increases more rapidly. When the reference signal has a falling jump, the second comparator drives the main discharging transistor to be turned on, so that the direct current-direct current converter circuit is grounded through the main discharging transistor; and the first comparator drives the main charging transistor to be turned off. The main power supply branch outputs the first discharge current to the output end of the direct current-direct current converter circuit through the main discharging transistor, so that the power supply voltage output by the output end of the power amplifier power supply circuit decreases more rapidly until the sampling voltage is less than the second reference voltage.

In a possible implementation, a non-inverting input end of the first comparator is configured to input the sampling voltage, an inverting input end of the first comparator is configured to input the first reference voltage, and an output end of the first comparator is coupled to a gate of the main charging transistor. A non-inverting input end of the second comparator is configured to input the sampling voltage, an inverting input end of the second comparator is configured to input the second reference voltage, and an output end of the second comparator is coupled to a gate of the main discharging transistor. The first reference voltage and the second reference voltage are obtained based on the reference signal, and the first reference voltage is less than the second reference voltage. When the reference signal has a rise jump, the first comparator outputs a low electrical level, and the main charging transistor is turned on, so that the direct current-direct current converter circuit is connected to the power supply voltage through the main charging transistor; and the second comparator outputs a low electrical level, so that the main discharging transistor is turned off. The main power supply branch outputs a first charge current to the output end of the direct current-direct current converter circuit through the main charging transistor, so that the power supply voltage output by the output end of the power amplifier power supply circuit increases more rapidly until the sampling voltage is greater than the first reference voltage. When the reference signal has a falling jump, the second comparator outputs a high electrical level, and the main discharging transistor is turned on, so that the direct current-direct current converter circuit is grounded through the main discharging transistor; and the first comparator outputs a high electrical level, so that the main charging transistor is turned off. The main power supply branch outputs the first discharge current to the output end of the direct current-direct current converter circuit through the main discharging transistor, so that the power supply voltage output by the output end of the power amplifier power supply circuit decreases more rapidly until the sampling voltage is less than the second reference voltage.

In a possible implementation, the first reference voltage and the second reference voltage are obtained based on the reference signal, and the first reference voltage is less than the second reference voltage. For a specific technical effect, refer to the technical effect of the previous implementation.

In a possible implementation, the first gate driving circuit includes an error amplifier, a first comparator, and a second comparator. The error amplifier is configured to: compare the input sampling voltage with the input reference signal, and output a first comparison result to the first comparator and the second comparator. The first comparator is configured to: compare the input first comparison result with a fifth reference voltage, and output a comparison result to the main charging transistor. The second comparator is configured to: compare the input first comparison result with a sixth reference voltage, and output a comparison result to the main discharging transistor. When the reference signal has a rise jump, a difference between the reference signal and the sampling voltage instantaneously becomes larger, and an error signal output by the error amplifier is also large. The first comparator drives the main charging transistor to be turned on, so that the direct current-direct current converter circuit is connected to a power supply voltage through the main charging transistor. The second comparator drives the main discharging transistor to be turned off. The main power supply branch outputs a first charge current to an output end of the direct current-direct current converter circuit through the main charging transistor, so that a power supply voltage output by an output end of the power amplifier power supply circuit increases more rapidly. As the power supply voltage and the sampling voltage gradually increase, the error signal gradually decreases. The main power supply branch stops outputting the first charge current to the output end of the direct current-direct current converter circuit. When the reference signal has a falling jump, the difference between the reference signal and the sampling voltage instantaneously becomes smaller, and the error signal output by the error amplifier is also small. The second comparator drives the main discharging transistor to be turned on, so that the direct current-direct current converter circuit is grounded through the main discharging transistor. The first comparator drives the main charging transistor to be turned off. The main power supply branch outputs a first discharge current to the output end of the direct current-direct current converter circuit through the main discharging transistor, so that the power supply voltage output by the output end of the power amplifier power supply circuit decreases more rapidly. As the power supply voltage and the sampling voltage gradually decrease, the error signal gradually increases. The main power supply branch stops outputting the first discharge current to the output end of the direct current-direct current converter circuit.

In a possible implementation, an inverting input end of the error amplifier is configured to input the sampling voltage, a non-inverting input end of the error amplifier is configured to input the reference signal, and an output end of the error amplifier is coupled to an inverting input end of the first comparator and an inverting input end of the second comparator. A non-inverting input end of the first comparator is configured to input the fifth reference voltage, and an output end of the first comparator is coupled to a gate of the main charging transistor. A non-inverting input end of the second comparator is configured to input the sixth reference voltage, and an output end of the second comparator is coupled to a gate of the main discharging transistor. When the reference signal has a rise jump, the difference between the reference signal and the sampling voltage instantaneously becomes larger, and the error signal is also large. When the error signal is greater than the fifth reference signal, the first comparator outputs a low electrical level, and the main charging transistor is turned on, so that the direct current-direct current converter circuit is connected to the power supply voltage through the main charging transistor. The second comparator outputs a low electrical level, so that the main discharging transistor is turned off. The main power supply branch outputs the first charge current to the output end of the direct current-direct current converter circuit through the main charging transistor, so that the power supply voltage output by the output end of the power amplifier power supply circuit increases more rapidly. As the power supply voltage and the sampling voltage gradually increase, the error signal gradually decreases. Until the error signal is less than the fifth reference voltage, the main power supply branch stops outputting the first charge current to the output end of the direct current-direct current converter circuit. When the reference signal has a falling jump, the difference between the reference signal and the sampling voltage instantaneously becomes smaller, and the error signal is also small. When the error signal is less than the sixth reference signal, the second comparator outputs a high electrical level, and the main discharging transistor is turned on, so that the direct current-direct current converter circuit is grounded through the main discharging transistor. The first comparator outputs a high electrical level, so that the main charging transistor is turned off. The main power supply branch outputs the first discharge current to the output end of the direct current-direct current converter circuit through the main discharging transistor, so that the power supply voltage output by the output end of the power amplifier power supply circuit decreases more rapidly. As the power supply voltage and the sampling voltage gradually decrease, the error signal gradually increases. Until the error signal is greater than the sixth reference voltage, the main power supply branch stops outputting the first discharge current to the output end of the direct current-direct current converter circuit.

In a possible implementation, the power amplifier power supply circuit includes a fifth comparator. The fifth comparator is configured to: compare the input first comparison result with a triangular wave signal, and output a comparison result to the direct current-direct current converter circuit, to adjust power supply of the direct current-direct current converter circuit. When the reference signal has a rise jump, the difference between the reference signal and the sampling voltage instantaneously becomes larger, the error signal is also large, and a duty of a modulation signal output by the fifth comparator increases. Therefore, the power supply voltage output by the direct current-direct current converter circuit is increased, so that the power supply voltage output by the direct current-direct current converter circuit fast follows the rise jump of the reference signal. When the reference signal has a falling jump, the reference signal is instantaneously less than the sampling voltage, the error signal output by the error amplifier is small, and the duty of the modulation signal output by the fifth comparator decreases. Therefore, the power supply voltage output by the direct current-direct current converter circuit is decreased, so that the power supply voltage output by the direct current-direct current converter circuit fast follows the falling jump of the reference signal.

In a possible implementation, a non-inverting input end of the fifth comparator is coupled to the output end of the error amplifier, an inverting input end of the fifth comparator is configured to input the triangular wave signal, and an output end of the fifth comparator is coupled to a control end of the direct current-direct current converter circuit, to adjust the power supply of the direct current-direct current converter circuit. When the reference signal has a rise jump, the difference between the reference signal and the sampling voltage instantaneously becomes larger, the error signal is also large, and the duty of the modulation signal output by the fifth comparator increases. Therefore, the power supply voltage output by the direct current-direct current converter circuit is increased, so that the power supply voltage output by the direct current-direct current converter circuit fast follows the rise jump of the reference signal. When the reference signal has a falling jump, the reference signal is instantaneously less than the sampling voltage, the error signal output by the error amplifier is small, and the duty of the modulation signal output by the fifth comparator decreases. Therefore, the power supply voltage output by the direct current-direct current converter circuit is decreased, so that the power supply voltage output by the direct current-direct current converter circuit fast follows the falling jump of the reference signal.

In a possible implementation, the first gate driving circuit further includes a first driving circuit and a second driving circuit. The comparison result output by the first comparator is output to the main charging transistor through the first driving circuit. The comparison result output by the second comparator is output to the main discharging transistor through the second driving circuit. The driving circuit is configured to supply a driving current to a power supply transistor.

In a possible implementation, the output end of the first comparator is coupled to the gate of the main charging transistor through the first driving circuit, and the output end of the second comparator is coupled to the gate of the main discharging transistor through the second driving circuit. The driving circuit is configured to supply a driving current to a power supply transistor.

In a possible implementation, the main charging transistor includes a plurality of first charging transistors connected in parallel, and the main discharging transistor includes a plurality of first discharging transistors connected in parallel. The power amplifier power supply circuit is configured to provide an enable signal, to control a quantity of opened or closed charging transistors in the plurality of first charging transistors and/or a quantity of opened or closed discharging transistors in the plurality of first discharging transistors. When the power supply voltage decreases, a current output by a single group of a first charging transistor and a first discharging transistor that are connected in series also decreases, and the enable signal selects more groups of first charging transistors and first discharging transistors that are connected in series to work. When the power supply voltage increases, a current output by a single group of a first charging transistor and a first discharging transistor that are connected in series also increases, and the enable signal selects fewer groups of first charging transistors and first discharging transistors that are connected in series to work. When a difference between a second target voltage and a first target voltage decreases, that is, an amplitude of the rise jump or the falling jump of the reference signal is small, a current required for the jump is also small, and the enable signal selects fewer groups of first charging transistors and first discharging transistors that are connected in series to work. When the difference between the second target voltage and the first target voltage increases, that is, the amplitude of the rise jump or the falling jump of the reference signal is large, the current required for the jump is also large, and the enable signal selects more groups of first charging transistors and first discharging transistors that are connected in series to work. A charge current or a discharge current supplied by a single group of a first charging transistor and a first discharging transistor that are connected in series is in direct proportional to a difference between a source gate voltage and a threshold voltage. When a threshold voltage of a power supply transistor in a plurality of groups of first charging transistors and first discharging transistors that are connected in series is smaller, the enable signal selects fewer groups of first charging transistors and first discharging transistors that are connected in series to work. When the threshold voltage of the power supply transistor in the plurality of groups of first charging transistors and first discharging transistors that are connected in series is larger, the enable signal selects more groups of first charging transistors and first discharging transistors that are connected in series to work.

In a possible implementation, the fast current charger circuit further includes an auxiliary power supply branch, and a current supplied by the auxiliary power supply branch is less than a current supplied by the main power supply branch. The auxiliary power supply branch is configured to compensate for overvoltage or undervoltage when the power supply voltage jumps, to accelerate stability of the power supply voltage.

In a possible implementation, the auxiliary power supply branch includes an auxiliary charging transistor and an auxiliary discharging transistor that are coupled in series, and a connection point between the auxiliary charging transistor and the auxiliary discharging transistor is configured to be coupled to the power supply end of the power amplifier. The auxiliary power supply branch further includes a second gate driving circuit. The second gate driving circuit is configured to: input a sampling voltage corresponding to the power supply voltage and a target voltage corresponding to the power supply voltage, and output a gate driving signal to the auxiliary charging transistor and the auxiliary discharging transistor. That is, the sampling voltage and the reference signal determine power supply of the auxiliary charging transistor and the auxiliary discharging transistor to the power amplifier.

In a possible implementation, the second gate driving circuit includes a third comparator and a fourth comparator. The third comparator is configured to: compare the input sampling voltage with an input third reference voltage, and output a comparison result to the auxiliary charging transistor. The fourth comparator is configured to: compare the input sampling voltage with an input fourth reference voltage, and output a comparison result to the auxiliary discharging transistor. When the third comparator drives the auxiliary charging transistor to be turned on so that the direct current-direct current converter circuit is connected to the power supply voltage through the auxiliary charging transistor, and the fourth comparator drives the auxiliary discharging transistor to be turned off, the auxiliary power supply branch outputs a second charge current to the output end of the direct current-direct current converter circuit through the auxiliary charging transistor, to alleviate undervoltage of the power supply voltage and accelerate stability of the power supply voltage. When the fourth comparator drives the auxiliary discharging transistor to be turned on so that the direct current-direct current converter circuit is grounded through the auxiliary discharging transistor, and the third comparator drives the auxiliary charging transistor to be turned off, the auxiliary power supply branch outputs a second discharge current to the output end of the direct current-direct current converter circuit through the auxiliary discharging transistor, to alleviate overvoltage of the power supply voltage and accelerate stability of the power supply voltage.

In a possible implementation, a non-inverting input end of the third comparator is configured to input the sampling voltage, an inverting input end of the third comparator is configured to input the third reference voltage, and an output end of the third comparator is coupled to a gate of the auxiliary charging transistor. A non-inverting input end of the fourth comparator is configured to input the sampling voltage, an inverting input end of the fourth comparator is configured to input the fourth reference voltage, and an output end of the fourth comparator is coupled to a gate of the auxiliary discharging transistor. If the sampling voltage is less than the third reference voltage (that is, the power supply voltage is undervoltaged), the third comparator outputs a low electrical level, and the auxiliary charging transistor is turned on, so that the direct current-direct current converter circuit is connected to the power supply voltage through the auxiliary charging transistor; and the fourth comparator outputs a low electrical level, so that the auxiliary discharging transistor is turned off. The auxiliary power supply branch outputs the second charge current to the output end of the direct current-direct current converter circuit through the auxiliary charging transistor, to alleviate undervoltage of the power supply voltage and accelerate stability of the power supply voltage. If the sampling voltage is greater than the fourth reference voltage (that is, the power supply voltage is overvoltaged), the fourth comparator outputs a high electrical level, and the auxiliary discharging transistor is turned on, so that the direct current-direct current converter circuit is grounded through the auxiliary discharging transistor; and the third comparator outputs a high electrical level, so that the auxiliary charging transistor is turned off. The auxiliary power supply branch outputs the second discharge current to the output end of the direct current-direct current converter circuit through the auxiliary discharging transistor, to alleviate overvoltage of the power supply voltage and accelerate stability of the power supply voltage.

In a possible implementation, the second gate driving circuit further includes a third driving circuit and a fourth driving circuit. The comparison result output by the third comparator is output to the auxiliary charging transistor through the third driving circuit. The comparison result output by the fourth comparator is output to the auxiliary discharging transistor through the fourth driving circuit. The driving circuit is configured to supply a driving current to a power supply transistor.

In a possible implementation, the output end of the third comparator is coupled to the gate of the auxiliary charging transistor through the third driving circuit. The output end of the fourth comparator is coupled to the gate of the auxiliary discharging transistor through the fourth driving circuit. The driving circuit is configured to supply a driving current to a power supply transistor.

In a possible implementation, the third reference voltage and the fourth reference voltage are obtained based on the reference signal, and the third reference voltage is less than the fourth reference voltage.

In a possible implementation, the direct current-direct current converter circuit includes a load inductor, a load capacitor, and a direct current charging transistor and a direct current discharging transistor that are coupled in series. A third connection point between the direct current charging transistor and the direct current discharging transistor is grounded by using the load capacitor, and is further configured to be coupled to the power supply end of the power amplifier by using the load inductor. This implementation provides a specific circuit structure of a buck circuit.

In a possible implementation, a linear amplifier and a linear amplifier power supply circuit are further included. The linear amplifier power supply circuit is configured to supply power to the linear amplifier. The linear amplifier is configured to supply power to the power amplifier. The first power supply voltage output by the direct current-direct current converter circuit and the fast current charger circuit that are connected in parallel may be considered as a low-frequency direct-current component, and the second power supply voltage output by the linear amplifier may be considered as a high-frequency alternating-current component. The first power supply voltage and the second power supply voltage are superimposed and then output to the power amplifier by using the output end of the power amplifier power supply circuit, to improve work efficiency of the power amplifier as much as possible.

In a possible implementation, a capacitor and a switch are further included. An output end of the linear amplifier is coupled to the output end of the power amplifier power supply circuit by using the capacitor, and the output end of the linear amplifier is further grounded by using the switch. When the switch is turned on, the direct current-direct current converter circuit and the fast current charger circuit that are connected in parallel may output the first power supply voltage to the power amplifier based on the reference signal. When the switch is turned off, the direct current-direct current converter circuit and the fast current charger circuit that are connected in parallel may output the first power supply voltage to the power amplifier based on the reference signal, and the linear amplifier may output the second power supply voltage to the power amplifier.

According to a third aspect, a communication apparatus is provided, and includes a power amplifier power supply circuit, a transmitter, a power amplifier, and a digital baseband processor. The power amplifier power supply circuit is the power amplifier power supply circuit according to the first aspect and any implementation of the first aspect. The digital baseband processor is coupled to the transmitter. The transmitter is configured to: output a radio frequency signal to the power amplifier, and output a reference signal to the power amplifier power supply circuit. The power amplifier power supply circuit is configured to supply power to the power amplifier. A power supply voltage output by the power amplifier power supply circuit may be adjusted based on a target power supply voltage of the PA at each symbol.

For a technical effect of the third aspect, refer to the technical effect of the first aspect and any implementation of the first aspect, or refer to the technical effect of the second aspect and any implementation of the second aspect.

### BRIEF DESCRIPTION OF DRAWINGS

FIG. 1A is a schematic of a structure of a communication apparatus according to an embodiment of this application;
FIG. 1B is a schematic of a structure of another communication apparatus according to an embodiment of this application;
FIG. 1C is a schematic of a relationship between a radio frequency signal and a power supply voltage output by a power supply circuit according to an embodiment of this application;
FIG. 2 is a schematic of a structure of a power supply circuit according to an embodiment of this application;
FIG. 3 is a schematic of a structure of another power supply circuit according to an embodiment of this application;
FIG. 4 is a schematic of a structure of still another power supply circuit according to an embodiment of this application;
FIG. 5 is a schematic of a working principle of a main power supply branch according to an embodiment of this application;
FIG. 6 is a schematic of a working principle of another main power supply branch according to an embodiment of this application; and
FIG. 7 is a schematic of a working principle of an auxiliary power supply branch according to an embodiment of this application.

### DESCRIPTION OF EMBODIMENTS

It should be noted that, in embodiments of this application, terms such as "first" and "second" are only used for a purpose of distinguishing between features of a same type, but should not be understood as an indication of relative importance, a quantity, a sequence, or the like.

In embodiments of this application, terms such as "example" or "for example" represent giving an example, an illustration, or a description. Any embodiment or design scheme described as "example" or "for example" in this application should not be explained as being more preferred or having more advantages than another embodiment or design scheme. Exactly, use of the terms such as "example" or "for example" is intended to present a related concept in a specific manner.

Terms "coupling" and "connection" in embodiments of this application should be understood in a broad sense. For example, the terms may refer to a physical direct connection, or may refer to an indirect connection implemented by using an electronic device, for example, a connection implemented by using a resistor, an inductor, a capacitor, or another electronic device.

A wireless communication-based communication apparatus such as a terminal device (for example, a mobile phone or a tablet computer) or a base station includes an integrated circuit, configured to receive and send a radio frequency signal, to perform wireless communication. For a part that transmits the radio frequency signal in the integrated circuit, to increase a gain of the radio frequency signal, power amplification by a PA needs to be performed on the radio frequency signal before the radio frequency signal is transmitted through an antenna.

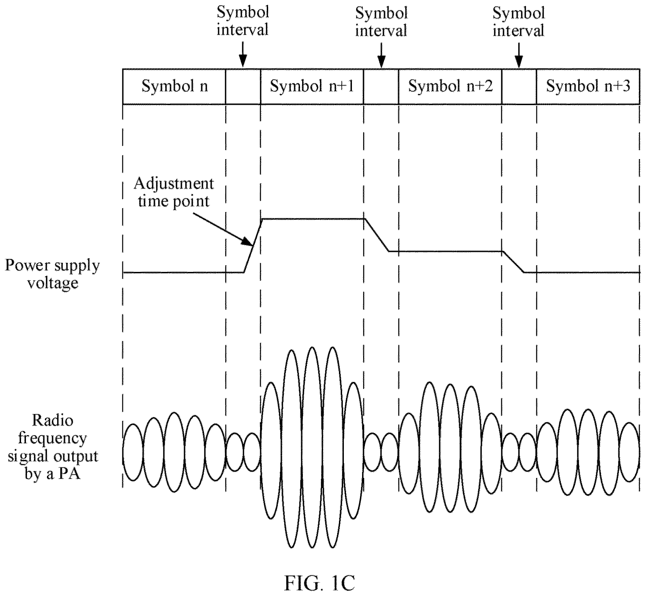

A symbol in embodiments of this application is an orthogonal frequency division multiplexing (orthogonal frequency division multiplexing, OFDM) symbol, and a symbol interval is a time period between adjacent OFDM symbols. For example, FIG. 1C shows a correspondence between a symbol and a symbol interval. There is a symbol interval between a symbol n and a symbol n+1, and there is a symbol interval between a symbol n+1 and a symbol n+2.

To improve work efficiency of the PA or another similar power device, currently, an independent power supply circuit is used to supply power to the PA or the another similar power device, to dynamically adjust a power supply voltage of the PA or the another similar power device, and therefore improve the work efficiency of the PA or the another similar power device. A reason why dynamically adjusting the power supply voltage of the PA or the another similar power device improves the work efficiency of the PA or the another similar power device is that transmit power of the PA or the another similar power device varies from time to time, and on the premise of ensuring linearity, a power supply voltage required by the PA or the another similar power device at a moment varies with instantaneous transmit power. Therefore, dynamically adjusting the power supply voltage of the PA or the another similar power device can improve the work efficiency of the PA or the another similar power device.

A power supply circuit of the PA or the another similar power device may use a new modulation technology, that is, symbol power tracking (symbol power tracking, SPT) modulation. A power supply voltage supplied to the PA is dynamically adjusted at a symbol level based on target power of the PA or the another similar power device, to reduce energy loss on the PA or the another similar power devices and improve the work efficiency. However, because the symbol interval is short (4.16 µs), it is a great design challenge to implement a jump of the output power supply voltage in short time. For example, in a scenario in which a wavelet interval is 240 kHz, time of each symbol is 4.16 µs, and a symbol time interval is only 290 ns. Therefore, embodiments of this application provide a power amplifier power supply circuit and a communication apparatus. By compensating a current for an output end of a first power supply circuit in the power amplifier power supply circuit, the first power supply circuit is accelerated to be stable in a target power supply voltage, to improve work efficiency of a PA or another similar power device.

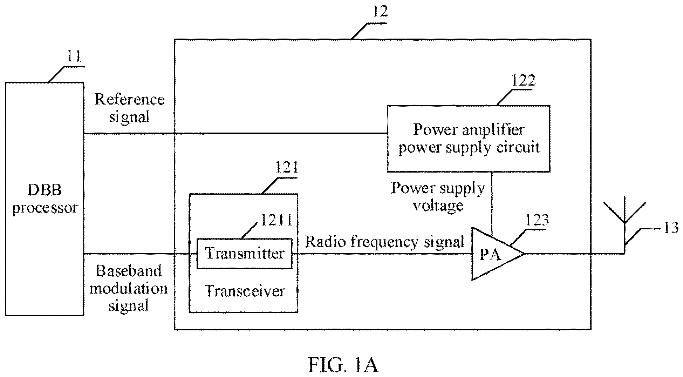

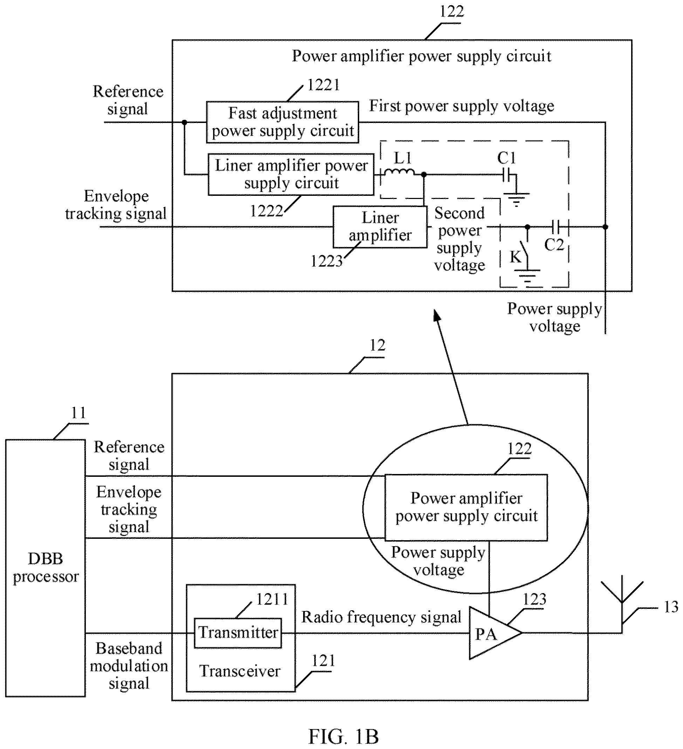

As shown in FIG. 1A and FIG. 1B, embodiments of this application provide a communication apparatus including a PA and a power amplifier power supply circuit. The communication apparatus includes a digital baseband (digital baseband, DBB) processor 11, an integrated circuit 12, and an antenna 13. In addition, the communication apparatus may further include a printed circuit board (not shown in the figure). The communication apparatus (for example, the digital baseband processor 11 and the integrated circuit 12 of the communication apparatus) may be fastened to the printed circuit board. The integrated circuit 12 may include a transceiver 121, a power amplifier power supply circuit 122, and a PA 123.

The transceiver 121 includes a transmitter 1211. The DBB processor 11 is configured to: output a low-frequency baseband modulation signal to the transmitter 1211, and output a reference signal to the power amplifier power supply circuit 122 (a power amplifier power supply circuit in FIG. 1A, or a fast adjustment power supply circuit 1221 or a linear amplifier power supply circuit 1222 in FIG. 1B) by using a digital analog converter (digital analog converter, DAC) (not shown in the figure, and may be located in the DBB 11, the transceiver 121, or the power amplifier power supply circuit 122) during a symbol interval of the baseband modulation signal based on a target power supply voltage of the PA 123 at each symbol. The reference signal is proportional to the target power supply voltage of the PA 123 at each symbol. Optionally, for FIG. 1B, the DBB processor 11 may further output an envelope tracking signal corresponding to the baseband modulation signal to the power amplifier power supply circuit 122 by using the DAC (not shown in the figure, and may be located in the DBB 11, the transceiver 121, or the power amplifier power supply circuit 122). The transmitter 1211 is configured to convert a low-frequency baseband signal into a high-frequency radio frequency signal. The PA 123 is configured to: perform power amplification on the radio frequency signal output by the transmitter 1211, and transmit the radio frequency signal through the antenna 13.

In FIG. 1A, the power amplifier power supply circuit 122 may be a fast adjustment power supply circuit, and the fast adjustment power supply circuit is configured to adjust a power supply voltage of the PA 123 at a symbol level based on the reference signal from the DBB processor 11, to implement SPT modulation. For example, FIG. 1C shows a correspondence between a power supply voltage output by the power amplifier power supply circuit 122, a radio frequency signal output by the PA 123, a symbol, and a symbol interval.

In FIG. 1B, the power amplifier power supply circuit 122 may include the fast adjustment power supply circuit 1221, the linear amplifier power supply circuit 1222, and a linear amplifier 1223; and optionally, may further include a first load inductor L1, a first load capacitor C1, a second load capacitor C2, and a switch K. Alternatively, the linear amplifier power supply circuit 1222 may use the fast adjustment power supply circuit provided in embodiments of this application. The fast adjustment power supply circuit 1221 is configured to adjust the power supply voltage of the PA 123 at the symbol level based on the reference signal from the DBB processor 11, to implement SPT modulation. An input end of the fast adjustment power supply circuit 1221 and an input end of the linear amplifier power supply circuit 1222 are configured to input the reference signal, and an output end of the fast adjustment power supply circuit 1221 is coupled to an output end of the power amplifier power supply circuit 122. An output end of the linear amplifier power supply circuit 1222 is grounded by using the first load inductor L1 and the first load capacitor C1, and is further coupled to the linear amplifier 1223 by using the first load inductor L1. An input end of the linear amplifier 1223 is configured to input an envelope tracking signal, and an output end of the linear amplifier 1223 is coupled to the output end of the power amplifier power supply circuit 122 (that is, coupled to the output end of the fast adjustment power supply circuit 1221) by using the second load capacitor C2 and is further grounded by using the switch K.

When the switch K is turned on, the fast adjustment power supply circuit 1221 may output a first power supply voltage to the PA 123 based on the reference signal from the DBB processor 11. When the switch K is turned off, the linear amplifier power supply circuit 1222 may output a power supply voltage to the linear amplifier 1223 based on the reference signal from the DBB processor 11, and the linear amplifier 1223 may output a second power supply voltage to the PA 123. In this case, the first power supply voltage output by the fast adjustment power supply circuit 1221 may be considered as a low-frequency direct-current component, and the second power supply voltage output by the linear amplifier 1223 may be considered as a high-frequency alternating-current component. The first power supply voltage and the second power supply voltage are superimposed and then output to the PA 123 by using the output end of the power amplifier power supply circuit 122, to improve work efficiency of the PA 123 as much as possible.

The following describes in detail a possible structure and a working principle of the foregoing fast adjustment power supply circuit.

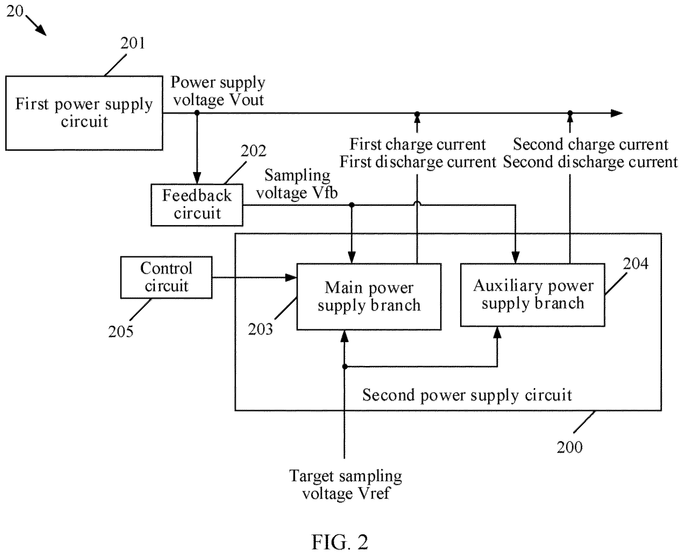

As shown in FIG. 2, an embodiment of this application provides a fast adjustment power supply circuit 20, including a feedback circuit 202, and a first power supply circuit 201 and a second power supply circuit 200 that are connected in parallel. The first power supply circuit 201 and the second power supply circuit 200 jointly supply power to a PA by using a power supply end of the PA. Power supply voltages output by the first power supply circuit 201 and the second power supply circuit 200 change based on a change of an envelope signal output by the PA. The second power supply circuit 200 includes a main power supply branch 203 and an auxiliary power supply branch 204. Optionally, the fast adjustment power supply circuit 20 may further include a control circuit 205.

An output end of the first power supply circuit 201 is coupled to an input end of the feedback circuit 202, and the output end of the first power supply circuit 201 (that is, an output end of the fast adjustment power supply circuit 20) is configured to output a power supply voltage Vout to the PA. An output end of the feedback circuit 202 is coupled to an input end of the main power supply branch 203 and an input end of the auxiliary power supply branch 204, and an output end of the second power supply circuit 200 (including an output end of the main power supply branch 203 and an output end of the auxiliary power supply branch 204) is coupled to the output end of the first power supply circuit 201.

The feedback circuit 202 is configured to sample the power supply voltage Vout to obtain a sampling voltage Vfb. The sampling voltage Vfb is equal to the power supply voltage Vout multiplied by a sampling coefficient of the feedback circuit 202.

The second power supply circuit 200 is also referred to as a fast current charger (fast current charger) circuit, and is configured to adjust a power supply voltage of the PA at a symbol level, that is, may adjust a power supply voltage of the PA at each symbol. In a possible implementation, the second power supply circuit 200 may output a first power supply voltage at a first symbol, and output a second power supply voltage at a second symbol that is set to be adjacent to the first symbol. The first power supply voltage is different from the second power supply voltage, and the second power supply circuit 200 may implement conversion from the first power supply voltage to the second power supply voltage at a first symbol interval between the first symbol and the second symbol, to adjust the power supply voltage of the PA at the symbol level.

For example, as shown in FIG. 1C, the second power supply circuit 200 may adjust the power supply voltage of the PA at a symbol interval between a symbol n (the first symbol) and a symbol n+1 (the second symbol) that are adjacent, so that the first power supply voltage output by the second power supply circuit 200 to the PA at the first symbol is different from the second power supply voltage output to the PA at the second symbol. The main power supply branch 203 is configured to: accelerate a jump of the power supply voltage Vout tracking the reference signal of the PA 123, and shorten jump time. The auxiliary power supply branch 204 is configured to compensate for overvoltage or undervoltage when the power supply voltage Vout jumps, to accelerate stability of the power supply voltage Vout. A current supplied by the auxiliary power supply branch 204 is less than a current supplied by the main power supply branch 203.

The main power supply branch 203 may input the sampling voltage Vfb and a reference signal Vref of the sampling voltage Vfb, and output a first current to the output end of the first power supply circuit 201 at a symbol interval of a radio frequency signal. The first current includes a first discharge current or a first discharge current. When the reference signal Vref increases to a first target voltage (that is, the reference signal of the PA 123 has a rise jump), and the sampling voltage Vfb is less than the first target voltage, the first charge current is output to the output end of the first power supply circuit 201. Alternatively, when the reference signal Vref decreases to a second target voltage (that is, the reference signal of the PA 123 has a falling jump), and the sampling voltage Vfb is greater than the second target voltage, the first discharge current is output to the output end of the first power supply circuit 201.

The reference signal Vref indicates a target power supply voltage of the PA 123 (that is, it is desirable to fast adjust the power supply voltage output from the output end of the power supply circuit 20). The target power supply voltage of the PA 123 is equal to the reference signal Vref divided by the sampling coefficient of the feedback circuit 202. When the reference signal has a rise jump (that is, the target power supply voltage of the PA 123 has a rise jump), the main power supply branch 203 outputs the first charge current to the output end of the first power supply circuit 201, to accelerate completion of a rise jump of the power supply voltage Vout output by the output end of the first power supply circuit 201. When the reference signal has a falling jump (that is, the target power supply voltage of the PA 123 has a falling jump), the main power supply branch 203 outputs the first discharge current to the output end of the first power supply circuit 201, to accelerate completion of a falling jump of the power supply voltage Vout output by the output end of the first power supply circuit 201.

The auxiliary power supply branch 204 may input the sampling voltage Vfb and the reference signal Vref, and output a second current to the output end of the first power supply circuit 201. The second current includes a second discharge current or a second discharge current. At the symbol interval of the radio frequency signal, when the sampling voltage Vfb is less than the reference signal Vref, the second charge current is output to the output end of the first power supply circuit 201, or when the sampling voltage Vfb is greater than the reference signal Vref, the second discharge current is output to the output end of the first power supply circuit 201.

When the main power supply branch 203 outputs the first charge current or the second discharge current to the output end of the first power supply circuit 201, overvoltage (the power supply voltage Vout is greater than the target power supply voltage of the PA 123) or undervoltage (the power supply voltage Vout is less than the target power supply voltage of the PA 123) of the power supply voltage Vout output by the output end of the first power supply circuit 201 may be caused. Therefore, the auxiliary power supply branch 204 is configured to compensate for overvoltage or undervoltage of the power supply voltage. To be specific, regardless of whether the reference signal Vref has a rise jump or a falling jump (that is, whether the target power supply voltage of the PA 123 has a rise jump or a falling jump), the auxiliary power supply branch 204 compensates the second charge current when the power supply voltage is undervoltaged, and compensates the second discharge current when the power supply voltage is overvoltaged, to accelerate stabilization of the power supply voltage Vout to the target power supply voltage of the PA 123.

The control circuit 205 is configured to control a magnitude of the first charge current or the first discharge current output by the main power supply branch 203.

The charge current in this embodiment of this application may mean that the output end of the first power supply circuit 201 is connected to a power supply voltage by using a transistor, to supply an additional charge current. The discharge current in this embodiment of this application may mean that the output end of the first power supply circuit 201 is grounded by using a transistor, to supply an additional discharge current.

It may be understood that conditions such as "the sampling voltage Vfb is less than the first target voltage", "the sampling voltage Vfb is greater than the second target voltage", "the sampling voltage Vfb is less than the reference signal Vref", and "the sampling voltage Vfb is greater than the reference signal Vref" may be extended, to avoid circuit oscillation and repeated charge and discharge. For example, the sampling voltage Vfb is less than (the first target voltage+a variation), the sampling voltage Vfb is greater than (the second target voltage+a variation), the sampling voltage Vfb is less than (the reference signal Vref+a variation), the sampling voltage Vfb is greater than (the reference signal Vref+a variation), or the like.

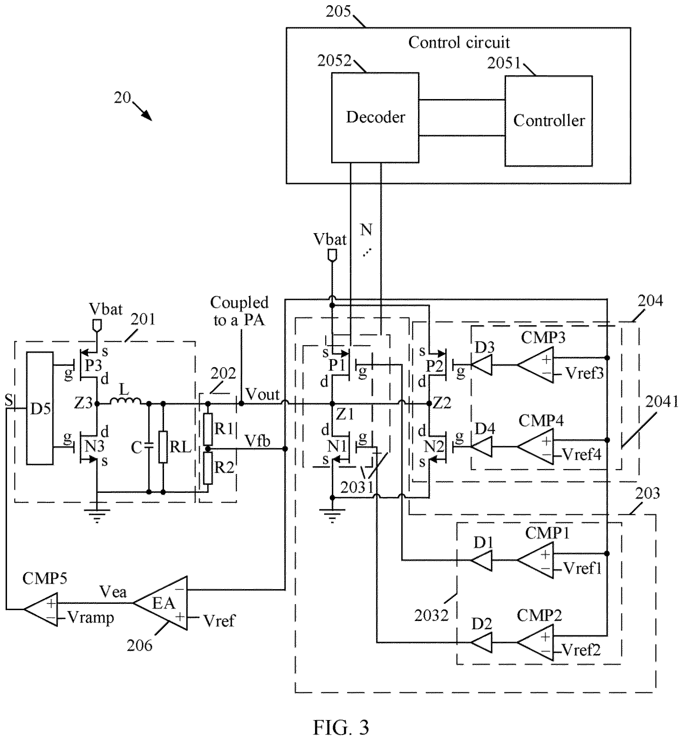

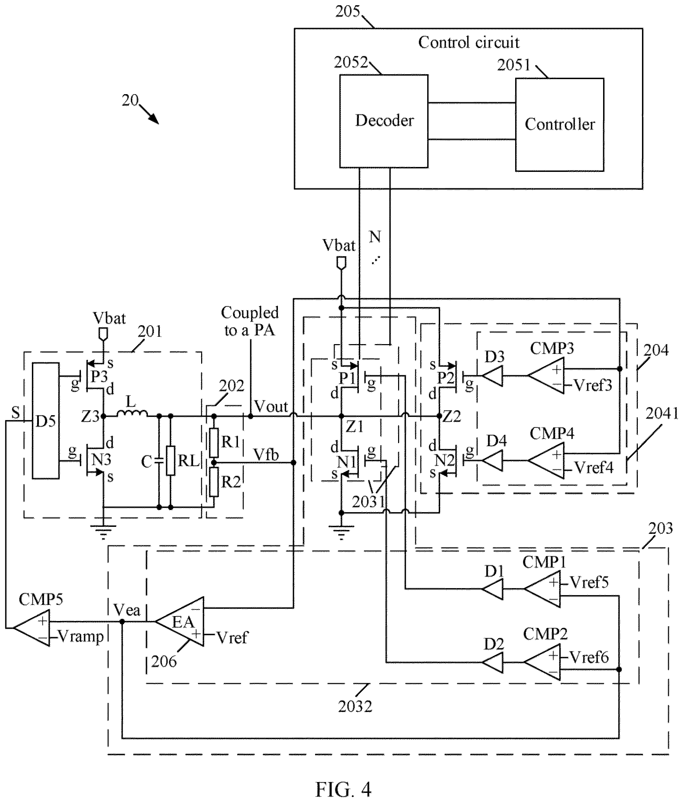

The following describes a possible structure of each circuit in the fast adjustment power supply circuit 20 with reference to FIG. 3 and FIG. 4.

The first power supply circuit 201 may be a direct current-direct current converter (direct current-direct current converter, DC-DC) circuit, for example, may use a boost (Boost) circuit, a buck (Buck) voltage, a buck-boost (Buck-Boost) circuit, or the like, to convert the power supply voltage Vbat into the power supply voltage Vout. For example, FIG. 3 and FIG. 4 show a first power supply circuit 201 that uses a buck circuit. The first power supply circuit 201 includes a fifth driving circuit D5, a load inductor L, a load capacitor C, a load resistor RL, and a direct current charging transistor P3 and a direct current discharging transistor N3 that are coupled in series. The direct current discharging transistor N3 may be one discharging transistor or a plurality of discharging transistors connected in series, and the direct current charging transistor P3 may be one charging transistor or a plurality of charging transistors connected in series. For example, the direct current charging transistor P3 may be a P-type transistor, and the direct current discharging transistor N3 may be an N-type transistor. A third connection point Z3 between the direct current charging transistor P3 and the direct current discharging transistor N3 is grounded by using the load capacitor C and the load resistor RL, and is coupled to the PA by using the load inductor L.

An input end of the fifth driving circuit D5 is a control end of the first power supply circuit 201, and an output end of the fifth driving circuit D5 is coupled to a gate g of the direct current discharging transistor N3 and a gate g of the direct current charging transistor P3. A drain d of the direct current discharging transistor N3 and a drain d of the direct current charging transistor P3 are coupled to a first end of the load inductor L, a source s of the direct current discharging transistor N3 is grounded, and a source of the direct current charging transistor P3 is coupled to a power supply (not shown in the figure, that is, an input power supply voltage Vbat). A second end (that is, an output end of the first power supply circuit 201) of the load inductor L is coupled to a first end of the load capacitor C and a first end of the load resistor RL, that is, the second end of the load inductor L is configured to output a power supply voltage Vout. A second end of the load capacitor C and a second end of the load resistor RL are grounded. The input end (the control end of the first power supply circuit 201) of the fifth driving circuit D5 is configured to input a modulation signal S having a variable duty (duty). The duty of the modulation signal S is adjusted by changing a ratio of turn-on time of the direct current discharging transistor N3 to turn-off time of the direct current charging transistor P3 through the fifth driving circuit D5, to control the power supply voltage Vout output by the first power supply circuit 201.

A feedback circuit 202 includes a resistor R1 and a resistor R2. The output end of the first power supply circuit 201 is coupled to a first end (used as an input end of the feedback circuit 202) of the resistor R1. A second end of the resistor R1 and a first end (used as an output end of the feedback circuit 202) of the resistor R2 are coupled to an input end of a main power supply branch 203 and an input end of an auxiliary power supply branch 204. A sampling voltage Vfb output by the output end of the feedback circuit 202 is equal to R2/(R1+R2) times the power supply voltage Vout output by the output end of the first power supply circuit 201, that is, Vfb= Vout*R2/(Rl +R2).

The main power supply branch 203 may have a plurality of implementations. In a possible implementation, as shown in FIG. 3, the main power supply branch 203 includes N compensation subcircuits 2031, where N is a positive integer; and optionally, may further include a first gate driving circuit 2032. Each compensation subcircuit 2031 includes a main discharging transistor N1 and a main charging transistor P1 that are coupled in series. The main discharging transistor N1 may be one discharging transistor or a plurality of discharging transistors connected in series, and the main charging transistor P1 may be one charging transistor or a plurality of charging transistors connected in series. For example, the main discharging transistor N1 may be an N-type transistor, and the main charging transistor P1 may be a P-type transistor. A drain d of the main discharging transistor N1 and a drain d of the main charging transistor P1 are coupled to the output end of the first power supply circuit 201, a source s of the main discharging transistor N1 is grounded, and a source s of the main charging transistor P1 is coupled to the power supply (not shown in the figure, that is, the input power supply voltage Vbat).

A connection point Z1 in a plurality of compensation subcircuits 2031 (the main charging transistor P1 and the main discharging transistor N1 that are coupled in series) is coupled to a power supply end of a power amplifier in parallel, that is, the main charging transistor P1 includes a plurality of first charging transistors in parallel, and the main discharging transistor N1 includes a plurality of first discharging transistors in parallel. Each compensation subcircuit 2031 includes a first charging transistor and a first discharging transistor that are coupled in series. A power amplifier power supply circuit may provide an enable signal, to control a quantity of opened or closed charging transistors in the plurality of first charging transistors and/or a quantity of opened or closed discharging transistors in the plurality of first discharging transistors.

The first gate driving circuit 2032 includes a first comparator CMP1 and a second comparator CMP2, and optionally, may further include a first driving circuit D1 and a second driving circuit D2. The first gate driving circuit 2032 is configured to: input the sampling voltage Vfb corresponding to the power supply voltage Vout and the reference signal Vref corresponding to the sampling voltage Vfb, and output a first gate driving signal to the main charging transistor P1 and the main discharging transistor N1.

The first comparator CMP1 is configured to: compare the input sampling voltage Vfb with an input first reference voltage Vref1, and output a comparison result to the main charging transistor P1. Optionally, the comparison result output by the first comparator CMP1 may be output to the main charging transistor P1 through the first driving circuit. The second comparator CMP2 is configured to: compare the input sampling voltage Vfb with an input second reference voltage Vref2, and output a comparison result to the main discharging transistor N1. Optionally, the comparison result output by the second comparator CMP2 may be output to the main discharging transistor N1 through the second driving circuit.

In a possible implementation, a non-inverting input end (+) of the first comparator CMP1 is configured to input the sampling voltage Vfb, an inverting input end (-) of the first comparator CMP1 is configured to input the first reference voltage Vref1, and an output end of the first comparator CMP1 is coupled to a gate g of the main charging transistor P1 through the first driving circuit D1. A non-inverting input end (+) of the second comparator CMP2 is configured to input the sampling voltage Vfb, an inverting input end (-) of the second comparator CMP2 is configured to input the second reference voltage Vref2, and an output end of the second comparator CMP2 is coupled to a gate g of the main discharging transistor N1 through the second driving circuit D2.

The first reference voltage Vref1 and the second reference voltage Vref2 are obtained based on the reference signal, and the first reference voltage Vref1 is less than or equal to the second reference voltage Vref2. For example, the first reference voltage Vref1 is equal to the reference signal minus a first variation Δ1, the second reference voltage Vref2 is equal to the reference signal plus the first variation Δ1, and the first variation Δ1 may be zero.

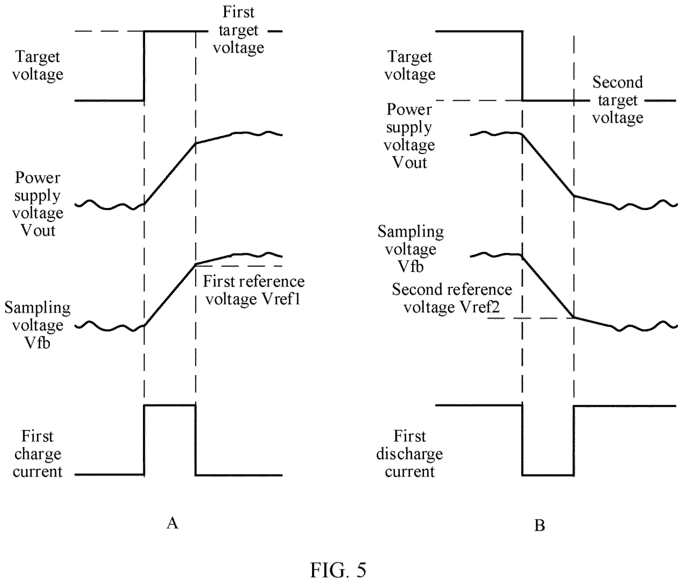

A working principle of the main power supply branch 203 shown in FIG. 3 is as follows: As shown in A in FIG. 5, when the reference signal Vref output by a DBB controller has a rise jump (reaches a first target voltage), the first comparator CMP1 outputs a low electrical level, and the main charging transistor P1 is turned on, so that the first power supply circuit 201 is connected to the power supply voltage Vbat through the main charging transistor P1; and the second comparator CMP2 outputs a low electrical level, so that the main discharging transistor N1 is turned off. The main power supply branch 203 outputs a first charge current to the output end of the first power supply circuit 201 through the main charging transistor P1, so that the power supply voltage Vout output by the output end of the fast adjustment power supply circuit 20 increases more rapidly until the sampling voltage Vfb is greater than the first reference voltage Vref1. As shown in B in FIG. 5, when the reference signal Vref output by the DBB controller has a falling jump (reaches a second target voltage), the second comparator CMP2 outputs a high electrical level, and the main discharging transistor N1 is turned on, so that the first power supply circuit 201 is grounded through the main discharging transistor N1; and the first comparator CMP1 outputs a high electrical level, so that the main charging transistor P1 is turned off. The main power supply branch 203 outputs a first discharge current to the output end of the first power supply circuit 201 through the main discharging transistor N1, so that the power supply voltage Vout output by the output end of the fast adjustment power supply circuit 20 decreases more rapidly until the sampling voltage Vfb is less than the second reference voltage Vref2.

In another possible implementation, a difference between the main power supply branch 203 shown in FIG. 4 and the main power supply branch 203 shown in FIG. 3 lies in:

The first gate driving circuit 2032 further includes an error amplifier (error amplifier, EA) 206. The error amplifier 206 is configured to: compare the input sampling voltage Vfb with the input reference signal Vref, and output a first comparison result to the first comparator CMP1 and the second comparator CMP2. The first comparator CMP1 is configured to: compare the input first comparison result with a fifth reference voltage Vref5, and output a comparison result to the main charging transistor P1. The second comparator CMP2 is configured to: compare the input first comparison result with a sixth reference voltage Vref6, and output a comparison result to the main discharging transistor N1.

In a possible implementation, an inverting input end (-) of the error amplifier 206 is configured to input the sampling voltage Vfb, and a non-inverting input end (+) of the error amplifier 206 is configured to input the reference signal Vref from the DBB processor 11. A value of the reference signal Vref may be the first target voltage or the second target voltage, and an output end of the error amplifier 206 is coupled to the inverting input end (-) of the first comparator CMP1 and the inverting input end (-) of the second comparator CMP2. The error amplifier 206 is configured to amplify a difference between the sampling voltage Vfb and the reference signal Vref. A larger difference indicates a larger error signal Vea output by the error amplifier 206. A smaller difference indicates a smaller error signal Vea output by the error amplifier 206.

The non-inverting input end (+) of the first comparator CMP1 is configured to input the fifth reference voltage Vref5, and the output end of the first comparator CMP1 is coupled to the gate g of the main charging transistor P1 through the first driving circuit D1. The non-inverting input end (+) of the second comparator CMP2 is configured to input the sixth reference voltage Vref6, and the output end of the second comparator CMP2 is coupled to the gate g of the main discharging transistor N1 through the second driving circuit D2.

The fifth reference voltage Vref5 is greater than the sixth reference voltage Vref6.

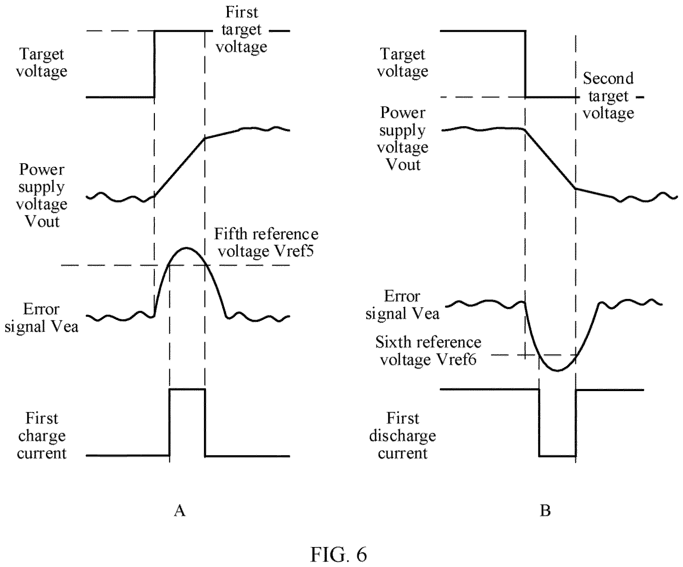

A working principle of the main power supply branch 203 shown in FIG. 4 is as follows: As shown in A in FIG. 6, when the reference signal Vref output by the DBB controller has a rise jump (reaches the first target voltage), the difference between the reference signal Vref and the sampling voltage Vfb instantaneously becomes larger, and the error signal Vea is also large. When the error signal Vea is greater than the fifth reference signal Vref5, the first comparator CMP1 outputs a low electrical level, and the main charging transistor P1 is turned on, so that the first power supply circuit 201 is connected to the power supply voltage Vbat through the main charging transistor P1. The second comparator CMP2 outputs a low electrical level, so that the main discharging transistor N1 is turned off. The main power supply branch 203 outputs the first charge current to the output end of the first power supply circuit 201 through the main charging transistor P1, so that the power supply voltage Vout output by the output end of the fast adjustment power supply circuit 20 increases more rapidly. As the power supply voltage Vout and the sampling voltage Vfb gradually increase, the error signal Vea gradually decreases. Until the error signal Vea is less than the fifth reference voltage Vref5, the main power supply branch 203 stops outputting the first charge current to the output end of the first power supply circuit 201. As shown in B in FIG. 6, when the reference signal Vref output by the DBB controller has a falling jump (reaches the second target voltage), the difference between the reference signal Vref and the sampling voltage Vfb instantaneously becomes smaller, and the error signal Vea is also small. When the error signal Vea is less than the sixth reference signal Vref6, the second comparator CMP2 outputs a high electrical level, and the main discharging transistor N1 is turned on, so that the first power supply circuit 201 is grounded through the main discharging transistor N1. The first comparator CMP1 outputs a high electrical level, so that the main charging transistor P1 is turned off. The main power supply branch 203 outputs the first discharge current to the output end of the first power supply circuit 201 through the main discharging transistor N1, so that the power supply voltage Vout output by the output end of the fast adjustment power supply circuit 20 decreases more rapidly. As the power supply voltage Vout and the sampling voltage Vfb gradually decrease, the error signal Vea gradually increases. Until the error signal Vea is greater than the sixth reference voltage Vref6, the main power supply branch 203 stops outputting the first discharge current to the output end of the first power supply circuit 201.

The auxiliary power supply branch 204 includes an auxiliary discharging transistor N2 and an auxiliary charging transistor P2 that are coupled in series, and optionally, may further include a second gate driving circuit 2041. The auxiliary discharging transistor N2 may be one discharging transistor or a plurality of discharging transistors connected in series, and the auxiliary charging transistor P2 may be one charging transistor or a plurality of charging transistors connected in series. For example, the auxiliary discharging transistor N2 may be an N-type transistor, and the auxiliary charging transistor P2 may be a P-type transistor. A connection point Z2 between the auxiliary charging transistor P2 and the auxiliary discharging transistor N2 is coupled to the power supply end of the power amplifier. A drain d of the auxiliary discharging transistor N2 and a drain d of the auxiliary charging transistor P2 are coupled to the output end of the first power supply circuit 201, a source s of the auxiliary discharging transistor N2 is grounded, and a source s of the auxiliary charging transistor P2 is coupled to the power supply (not shown in the figure, that is, the input power supply voltage Vbat).

The second gate driving circuit 2041 includes a third comparator CMP3 and a fourth comparator CMP4, and optionally, further includes a third driving circuit D3 and a fourth driving circuit D4. The second gate driving circuit 2041 is configured to: input the sampling voltage Vfb corresponding to the power supply voltage Vout and the reference signal Vref corresponding to the sampling voltage Vfb, and output a second gate driving signal to the auxiliary charging transistor P2 and the auxiliary discharging transistor N2.

The third comparator CMP3 is configured to: compare the input sampling voltage Vfb with an input third reference voltage Vref3, and output a comparison result to the auxiliary charging transistor P2. Optionally, the comparison result output by the third comparator CMP3 is output to the auxiliary charging transistor P2 through the third driving circuit D3. The fourth comparator CMP4 is configured to: compare the input sampling voltage with an input fourth reference voltage Vref4, and output a comparison result to the auxiliary discharging transistor N2. Optionally, the comparison result output by the fourth comparator CMP4 is output to the auxiliary discharging transistor N2 through the fourth driving circuit D4.

In a possible implementation, a non-inverting input end (+) of the third comparator CMP3 is configured to input the sampling voltage Vfb, an inverting input end (-) of the third comparator CMP3 is configured to input the third reference voltage Vref3, and an output end of the third comparator CMP3 is coupled to a gate g of the auxiliary charging transistor P2 through the third driving circuit D3. A non-inverting input end (+) of the fourth comparator CMP4 is configured to input the sampling voltage Vfb, an inverting input end (-) of the fourth comparator CMP4 is configured to input the fourth reference voltage Vref4, and an output end of the fourth comparator CMP4 is coupled to a gate g of the auxiliary discharging transistor N2 through the fourth driving circuit D4.

The third reference voltage Vref3 and the fourth reference voltage Vref4 are obtained based on the reference signal, and the third reference voltage is less than or equal to the fourth reference voltage. For example, the third reference voltage Vref3 is equal to the reference signal minus a second variation Δ2, the fourth reference voltage Vref4 is equal to the reference signal plus the second variation Δ2, and the second variation Δ2 may be zero. The first variation Δ1 may be greater than the second variation Δ2, and compensation of the first charge current may be stopped in advance to avoid overvoltage caused by overcompensation, or compensation of the first discharge current may be stopped in advance to avoid undervoltage caused by overcompensation.

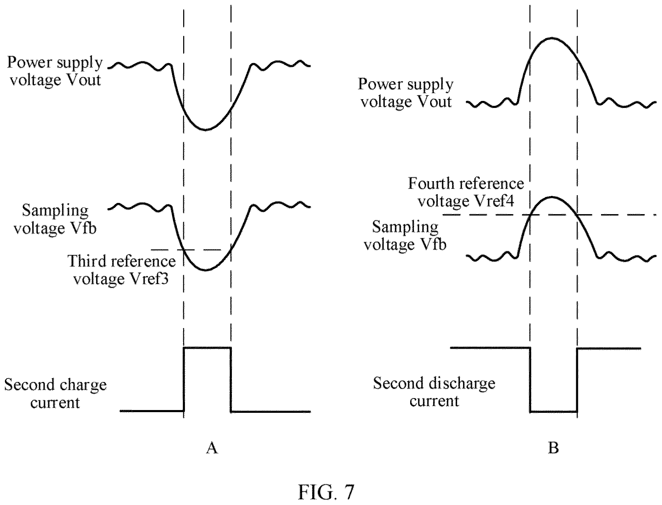

A working principle of the auxiliary power supply branch 204 is as follows: As shown in A in FIG. 7, when the reference signal Vref output by the DBB controller has a rise jump (reaches the first target voltage), or when the reference signal Vref output by the DBB controller has a falling jump (reaches the second target voltage), if the sampling voltage Vfb is less than the third reference voltage Vref3 (that is, the power supply voltage Vout is undervoltaged), the third comparator CMP3 outputs a low electrical level, and the auxiliary charging transistor P2 is turned on, so that the first power supply circuit 201 is connected to the power supply voltage Vbat through the auxiliary charging transistor P2; and the fourth comparator CMP4 outputs a low electrical level, so that the auxiliary discharging transistor N2 is turned off. The auxiliary power supply branch 204 outputs the second charge current to the output end of the first power supply circuit 201 through the auxiliary charging transistor P2, to alleviate undervoltage of the power supply voltage Vout and accelerate stability of the power supply voltage Vout. As shown in B in FIG. 7, when the reference signal Vref output by the DBB controller has a rise jump (reaches the first target voltage), or when the reference signal Vref output by the DBB controller has a falling jump (reaches the second target voltage), if the sampling voltage Vfb is greater than the fourth reference voltage Vref4 (that is, the power supply voltage Vout is overvoltaged), the fourth comparator CMP4 outputs a high electrical level, and the auxiliary discharging transistor N2 is turned on, so that the first power supply circuit 201 is grounded through the auxiliary discharging transistor N2; and the third comparator CMP3 outputs a high electrical level, so that the auxiliary charging transistor P2 is turned off. The auxiliary power supply branch 204 outputs the second discharge current to the output end of the first power supply circuit 201 through the auxiliary discharging transistor N2, to alleviate overvoltage of the power supply voltage Vout and accelerate stability of the power supply voltage Vout.

Optionally, as shown in FIG. 3, the fast adjustment power supply circuit 20 may further include an error amplifier 206 and a fifth comparator CMP5. Alternatively, as shown in FIG. 4, the fast adjustment power supply circuit 20 may further include a fifth comparator CMP5. The fifth comparator CMP5 is configured to: compare the input first comparison result with a triangular wave signal, and output a comparison result to the first power supply circuit 201, to adjust power supply of the first power supply circuit 201. In a possible implementation, an inverting input end (-) of the error amplifier 206 is configured to input the sampling voltage Vfb, and a non-inverting input end (+) of the error amplifier 206 is configured to input the reference signal Vref from the DBB processor 11. A value of the reference signal Vref may be the first target voltage or the second target voltage. An output end of the error amplifier 206 is coupled to a non-inverting input end (+) of the fifth comparator CMP5, an inverting input end (-) of the fifth comparator CMP5 is configured to input the triangular wave signal Vramp, and an output end of the fifth comparator CMP5 is coupled to the control end of the first power supply circuit 201.

The error amplifier 206 is configured to amplify a difference between the sampling voltage Vfb and the reference signal Vref. A larger difference indicates a larger error signal Vea output by the error amplifier 206. A smaller difference indicates a smaller error signal Vea output by the error amplifier 206. The fifth comparator CMP5 compares the error signal Vea with the triangular wave signal Vramp, to output a modulation signal S having a variable duty (duty).

When the reference signal Vref has a rise jump (that is, the reference signal Vref reaches the first target voltage), the difference between the reference signal Vref and the sampling voltage Vfb instantaneously becomes larger, the error signal Vea is also large, and the duty of the modulation signal S output by the fifth comparator CMP5 increases. The modulation signal S controls the fifth driving circuit D5 to prolong turn-on time of the direct current charging transistor P3 (that is, turn-off time of the direct current discharging transistor N3) and shorten turn-on time of the direct current discharging transistor N3 (that is, turn-off time of the direct current charging transistor P3). Therefore, the power supply voltage Vout output by the first power supply circuit 201 is increased, so that the power supply voltage Vout output by the first power supply circuit 201 fast follows the rise jump of the reference signal Vref.

When the reference signal Vref has a falling jump (that is, the reference signal Vref reaches the second target voltage), the reference signal Vref is instantaneously less than the sampling voltage Vfb, the error signal Vea output by the error amplifier 206 is small, and the duty of the modulation signal S output by the fifth comparator CMP5 is reduced. The modulation signal S controls the fifth driving circuit D5 to prolong turn-on time of the direct current discharging transistor N3 (that is, turn-off time of the direct current charging transistor P3) and shorten turn-on time of the direct current charging transistor P3 (that is, turn-off time of the direct current discharging transistor N3). Therefore, the power supply voltage Vout output by the first power supply circuit 201 is reduced, so that the power supply voltage Vout output by the first power supply circuit 201 fast follows the falling jump of the reference signal Vref.

It should be noted that, as described above, the sampling voltage Vfb output by the feedback circuit 202 is equal to R2/(R1+R2) times the power supply voltage Vout output by the output end of the first power supply circuit 201, that is, the sampling coefficient of the feedback circuit 202 is R2/(R1+R2). In this case, Vfb=Vout*R2/(R1+R2). The error amplifier 206 and the fifth comparator CMP5 implement that the sampling voltage Vfb follows the reference signal Vref (that is, an error in an ideal situation is zero). Therefore, the reference signal Vref=a target power supply voltage of a PA 123 *R2/(R1+R2). The DBB processor 11 may output the reference signal Vref based on a proportional relationship.

The control circuit 205 includes a controller 2051 and a decoder 2052. The controller 2051 may output the control signal to the decoder, and the decoder 2052 decodes the control signal to select at least one compensation subcircuit 2031 in the N compensation subcircuits 2031 to work. For example, the decoder 2052 outputs an enable signal to any compensation subcircuit 2031, to control opening and closing of any compensation subcircuit 2031. Specifically, the controller 2051 may output the control signal to the decoder 2052 based on at least one of the following information: the power supply voltage Vbat, a difference between the second target voltage and the first target voltage, and process corner information of a transistor in the compensation subcircuit 2031. The process corner information includes a threshold voltage of the transistor, and the control signal may indicate a quantity of working compensation subcircuits 2031. The decoder 2052 may be an M-to- 2*^{M}* (2*^{M}* ≥N) decoder, that is, the controller 2051 may output M-bit control signals to the decoder 2052, and the decoder 2052 may decode the M-bit control signals into 2*^{M}* -bit enable signals. N-bit enable signals in the 2*^{M}* -bit enable signals are respectively used to control whether the N compensation subcircuits 2031 work.

For example, when the power supply voltage Vbat decreases, a current output by a single compensation subcircuit 2031 also decreases, and the control signal may control the decoder 2052 to output the enable signal to select more compensation subcircuits 2031 to work. When the power supply voltage Vbat increases, a current output by a single compensation subcircuit 2031 also increases, and the control signal may control the decoder 2052 to output the enable signal to select fewer compensation subcircuits 2031 to work. When the difference between the second target voltage and the first target voltage decreases, that is, the amplitude of the rise jump or the falling jump of the reference signal Vref is small, a current required for the jump is also small, and the control signal may control the decoder 2052 to output the enable signal to select fewer compensation subcircuits 2031 to work. When the difference between the second target voltage and the first target voltage increases, that is, the amplitude of the rise jump or the falling jump of the reference signal Vref is large, a current required for the jump is also large, and the control signal may control the decoder 2052 to output the enable signal to select more compensation subcircuits 2031 to work. A charge current or a discharge current supplied by a single compensation subcircuit 2031 is in direct proportional to a difference (Vgs-Vth) between a source gate voltage and the threshold voltage. When the threshold voltage of the transistor in the N compensation subcircuits 2031 is smaller, the control signal may control the decoder 2052 to output the enable signal to select fewer compensation subcircuits 2031 to work. When the threshold voltage of the transistor in the N compensation subcircuits 2031 is larger, the control signal may control the decoder 2052 to output the enable signal to select more compensation subcircuits 2031 to work.

In the power amplifier power supply circuit and the communication apparatus provided in embodiments of this application, the first power supply circuit supplies power to the power amplifier, and the second power supply circuit adjusts the power supply voltage of the power amplifier at the symbol level. Because the envelope signal that determines transmit power of the power amplifier or another similar power device changes more rapidly with further evolution of a protocol, it is introduced to adjust the power supply voltage at the symbol level. A power supply voltage required by the power amplifier or the another similar power device at a moment varies with instantaneous transmit power. Therefore, dynamically adjusting the power supply voltage of the power amplifier or the another similar power device can improve work efficiency of the power amplifier or the another similar power device.

The controller in embodiments of this application may be a chip, for example, may be a field programmable gate array (field programmable gate array, FPGA), an application-specific integrated circuit (application-specific integrated circuit, ASIC), a system on chip (system on chip, SoC), a central processing unit (central processing unit, CPU), a network processor (network processor, NP), a digital signal processing circuit (digital signal processor, DSP), a micro controller unit (micro controller unit, MCU), a programmable logic device (programmable logic device, PLD) or another integrated chip.

A person of ordinary skill in the art may be aware that, in combination with the examples described in embodiments disclosed in this specification, modules and algorithm steps may be implemented by electronic hardware or a combination of computer software and electronic hardware. Whether functions are performed in a hardware or software manner depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and module, refer to a corresponding process in the foregoing method embodiments, and details are not described herein again.

In the several embodiments provided in this application, it should be understood that the disclosed system, device, and method may be implemented in other manners. For example, the described device embodiment is merely an example. For example, the module division is merely logical function division and may be other division in actual implementation. For example, a plurality of modules or components may be combined or integrated into another device, or some features may be ignored or not performed. In addition, the displayed or discussed mutual couplings or direct couplings or communication connections may be implemented through some interfaces. The indirect couplings or communication connections between the devices or modules may be implemented in electronic, mechanical, or other forms.

The modules described as separate parts may or may not be physically separate, and parts displayed as modules may or may not be physical modules, may be located in one device, or may be distributed on a plurality of devices. Some or all of the modules may be selected based on an actual requirement to achieve the objectives of the solutions of embodiments.

In addition, functional modules in embodiments of this application may be integrated into one device, or each of the modules may exist alone physically, or two or more modules are integrated into one device.

All or some of the foregoing embodiments may be implemented by software, hardware, firmware, or any combination thereof. When a software program is used to implement embodiments, all or some of embodiments may be implemented in a form of a computer program product. The computer program product includes one or more computer instructions. When the computer program instructions are loaded and executed on a computer, all or some of the procedures or functions according to embodiments of this application are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (Digital Subscriber Line, DSL)) or wireless (for example, infrared, radio, or microwave) manner. The computer-readable storage medium may be any usable medium accessible by a computer, or a data storage device, for example, a server or a data center, integrating one or more usable media. The usable medium may be a magnetic medium (for example, a floppy disk, a hard disk, or a magnetic tape), an optical medium (for example, a DVD), a semiconductor medium (for example, a solid-state drive (solid-state drive, SSD)), or the like.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power amplifier power supply circuit, comprising a first power supply circuit and a second power supply circuit that are connected in parallel, wherein the first power supply circuit and the second power supply circuit jointly supply power to a power amplifier by using a power supply end of the power amplifier;
the second power supply circuit is configured to adjust a power supply voltage of the power amplifier at a symbol level; and
power supply voltages output by the second power supply circuit and the first power supply circuit change based on a change of an envelope signal output by the power amplifier.

2. The power amplifier power supply circuit according to claim 1, wherein
the second power supply circuit is configured to: output a first power supply voltage at a first symbol, and output a second power supply voltage at a second symbol, wherein the first symbol and the second symbol are set to be adjacent, and a first symbol interval is set between the first symbol and the second symbol; and
the first power supply voltage is different from the second power supply voltage, and the second power supply circuit is configured to implement conversion from the first power supply voltage to the second power supply voltage at the first symbol interval, to adjust the power supply voltage of the power amplifier at the symbol level.

3. The power amplifier power supply circuit according to claim 1 or 2, wherein the first power supply circuit is a direct current-direct current converter circuit, and the second power supply circuit is a fast current charger circuit.

4. The power amplifier power supply circuit according to any one of claims 1 to 3, wherein
the second power supply circuit comprises a main power supply branch, the main power supply branch comprises a main charging transistor and a main discharging transistor that are coupled in series, and a connection point between the main charging transistor and the main discharging transistor is configured to be coupled to the power supply end of the power amplifier; and
the main power supply branch further comprises a first gate driving circuit, wherein the first gate driving circuit is configured to: input a sampling voltage corresponding to the power supply voltage and a reference signal corresponding to the sampling voltage, and output a gate driving signal to the main charging transistor and the main discharging transistor.

5. The power amplifier power supply circuit according to claim 4, wherein the first gate driving circuit comprises a first comparator and a second comparator, wherein
the first comparator is configured to: compare the input sampling voltage with an input first reference voltage, and output a comparison result to the main charging transistor; and
the second comparator is configured to: compare the input sampling voltage with an input second reference voltage, and output a comparison result to the main discharging transistor.

6. The power amplifier power supply circuit according to claim 5, wherein
a non-inverting input end of the first comparator is configured to input the sampling voltage, an inverting input end of the first comparator is configured to input the first reference voltage, and an output end of the first comparator is coupled to a gate of the main charging transistor; and
a non-inverting input end of the second comparator is configured to input the sampling voltage, an inverting input end of the second comparator is configured to input the second reference voltage, and an output end of the second comparator is coupled to a gate of the main discharging transistor.

7. The power amplifier power supply circuit according to claim 5 or 6, wherein the first reference voltage and the second reference voltage are obtained based on the reference signal, and the first reference voltage is less than the second reference voltage.

8. The power amplifier power supply circuit according to claim 4, wherein the first gate driving circuit comprises an error amplifier, a first comparator, and a second comparator, wherein
the error amplifier is configured to: compare the input sampling voltage with the input reference signal, and output a first comparison result to the first comparator and the second comparator;
the first comparator is configured to: compare the input first comparison result with a fifth reference voltage, and output a comparison result to the main charging transistor; and
the second comparator is configured to: compare the input first comparison result with a sixth reference voltage, and output a comparison result to the main discharging transistor.

9. The power amplifier power supply circuit according to claim 8, wherein
an inverting input end of the error amplifier is configured to input the sampling voltage, a non-inverting input end of the error amplifier is configured to input the reference signal, and an output end of the error amplifier is coupled to an inverting input end of the first comparator and an inverting input end of the second comparator;
a non-inverting input end of the first comparator is configured to input the fifth reference voltage, and an output end of the first comparator is coupled to a gate of the main charging transistor; and
a non-inverting input end of the second comparator is configured to input the sixth reference voltage, and an output end of the second comparator is coupled to a gate of the main discharging transistor.

10. The power amplifier power supply circuit according to claim 8 or 9, wherein the power amplifier power supply circuit further comprises a fifth comparator, wherein
the fifth comparator is configured to: compare the input first comparison result with a triangular wave signal, and output a comparison result to the first power supply circuit, to adjust power supply of the first power supply circuit.

11. The power amplifier power supply circuit according to claim 10, wherein a non-inverting input end of the fifth comparator is coupled to the output end of the error amplifier, an inverting input end of the fifth comparator is configured to input the triangular wave signal, and an output end of the fifth comparator is coupled to a control end of the first power supply circuit.

12. The power amplifier power supply circuit according to any one of claims 4 to 7, wherein the first gate driving circuit further comprises a first driving circuit and a second driving circuit;
the comparison result output by the first comparator is output to the main charging transistor through the first driving circuit; and
the comparison result output by the second comparator is output to the main discharging transistor through the second driving circuit.

13. The power amplifier power supply circuit according to any one of claims 3 to 8, wherein the main charging transistor comprises a plurality of first charging transistors connected in parallel, and the main discharging transistor comprises a plurality of first discharging transistors connected in parallel; and
the power amplifier power supply circuit is configured to provide an enable signal, to control a quantity of opened or closed charging transistors in the plurality of first charging transistors and/or a quantity of opened or closed discharging transistors in the plurality of first discharging transistors.

14. The power amplifier power supply circuit according to any one of claims 4 to 13, wherein
the second power supply circuit further comprises an auxiliary power supply branch, and a current supplied by the auxiliary power supply branch is less than a current supplied by the main power supply branch.

15. The power amplifier power supply circuit according to claim 14, wherein
the auxiliary power supply branch comprises an auxiliary charging transistor and an auxiliary discharging transistor that are coupled in series, and a connection point between the auxiliary charging transistor and the auxiliary discharging transistor is configured to be coupled to the power supply end of the power amplifier; and
the auxiliary power supply branch further comprises a second gate driving circuit, wherein the second gate driving circuit is configured to: input the sampling voltage corresponding to the power supply voltage and a target voltage corresponding to the power supply voltage, and output a gate driving signal to the auxiliary charging transistor and the auxiliary discharging transistor.

16. The power amplifier power supply circuit according to claim 14, wherein the second gate driving circuit comprises a third comparator and a fourth comparator, wherein
the third comparator is configured to: compare the input sampling voltage with an input third reference voltage, and output a comparison result to the auxiliary charging transistor; and
the fourth comparator is configured to: compare the input sampling voltage with an input fourth reference voltage, and output a comparison result to the auxiliary discharging transistor.

17. The power amplifier power supply circuit according to claim 16, wherein
a non-inverting input end of the third comparator is configured to input the sampling voltage, an inverting input end of the third comparator is configured to input the third reference voltage, and an output end of the third comparator is coupled to a gate of the auxiliary charging transistor; and
a non-inverting input end of the fourth comparator is configured to input the sampling voltage, an inverting input end of the fourth comparator is configured to input the fourth reference voltage, and an output end of the fourth comparator is coupled to a gate of the auxiliary discharging transistor.

18. The power amplifier power supply circuit according to claim 16 or 17, wherein the second gate driving circuit further comprises a third driving circuit and a fourth driving circuit;
the comparison result output by the third comparator is output to the auxiliary charging transistor through the third driving circuit; and
the comparison result output by the fourth comparator is output to the auxiliary discharging transistor through the fourth driving circuit.

19. The power amplifier power supply circuit according to claim 18, wherein
the output end of the third comparator is coupled to the gate of the auxiliary charging transistor through the third driving circuit; and
the output end of the fourth comparator is coupled to the gate of the auxiliary discharging transistor through the fourth driving circuit.

20. The power amplifier power supply circuit according to any one of claims 16 to 19, wherein the third reference voltage and the fourth reference voltage are obtained based on the reference signal, and the third reference voltage is less than the fourth reference voltage.

21. The power amplifier power supply circuit according to any one of claims 1 to 20, wherein the first power supply circuit comprises a load inductor, a load capacitor, and a direct current charging transistor and a direct current discharging transistor that are coupled in series; and
a third connection point between the direct current charging transistor and the direct current discharging transistor is grounded by using the load capacitor, and is further configured to be coupled to the power supply end of the power amplifier by using the load inductor.

22. The power amplifier power supply circuit according to any one of claims 1 to 21, further comprising a linear amplifier and a linear amplifier power supply circuit, wherein the linear amplifier power supply circuit is configured to supply power to the linear amplifier; and
the linear amplifier is configured to supply power to the power amplifier.

23. The power amplifier power supply circuit according to claim 22, further comprising a capacitor and a switch; and
an output end of the linear amplifier is coupled to an output end of the power amplifier power supply circuit by using the capacitor, and the output end of the linear amplifier is further grounded by using the switch.

24. A communication apparatus, comprising a transmitter, a power amplifier, a digital baseband processor, and the power amplifier power supply circuit according to any one of claims 1 to 23, wherein the digital baseband processor is coupled to the transmitter; the transmitter is configured to: output a radio frequency signal to the power amplifier, and output a reference signal to the power amplifier power supply circuit; and the power amplifier power supply circuit is configured to supply power to the power amplifier.
